# EUROPEAN PATENT APPLICATION

(11) **EP 4 765 196 A1**
(43) Date of publication of application: **24.06.2026**
(21) Application number: 24220476.6
(22) Date of filing: 17.12.2024
(51) Int. Cl.: H01L 21/67

(54) **APPARATUS FOR JOINING AND BONDING SUBSTRATES AND METHODS THEREFORE**

(71) Applicant: ASML Netherlands B.V., 5500 AH Veldhoven (NL)
(72) Inventor: PELLEMANS, Henricus, Petrus, Maria, 5500 AH Veldhoven (NL); RENKENS, Michael, Jozefa, Mathijs, 5500 AH Veldhoven (NL); KOOLE, Roelof, 5500 AH Veldhoven (NL); BEUKMAN, Arjan, Johannes, Anton, 5500 AH Veldhoven (NL); BANINE, Vadim, Yevgenyevich, 5500 AH Veldhoven (NL)
(74) Representative: ASML Netherlands B.V.

(57) **Abstract**

The present invention provides an apparatus for bonding at least one die to a substrate , the apparatus comprising: a metrology station within the apparatus, the metrology station comprising at least one sensor , and a bonding station within the apparatus, the bonding station being configured to bond at least one donor substrate to an acceptor substrate, wherein the apparatus is configured to measure initially, using the sensor in the metrology station, at least one characteristic of the at least one donor substrate, a carrier substrate configured to support the at least one donor substrate prior to bonding and/or the acceptor substrate, to bond the at least one donor substrate to the acceptor substrate in the bonding station, and to measure subsequently at least one characteristic of the bonded donor and/or acceptor substrate in the metrology station.

## Description

### TECHNICAL FIELD

The present disclosure relates generally to an apparatus configured to join at least one substrate and a further substrate, methods for the apparatus and a method of configuring an apparatus.

### BACKGROUND

In manufacturing processes of integrated circuits (ICs), multiple substrates (which may be finished or unfinished ICs, e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple substrates. These specific portions may be aligned in three-dimensional space to ensure functional connectivity.

Alignment of the substrates, which may each have multiple fabrication layers, different critical dimensions, different nodes, packaging, etc., may require different techniques than those used for lithography during fabrication. As the physical sizes of IC components continue to shrink, and their structures continue to become more complex, accuracy in integration is becoming more important.

Although stacking the die on substrate is beneficial in increasing functionality, there are improvements to be made in bonding with high speed whilst placing the dies with high accuracy to meet desired electrical performance.

### SUMMARY

According to an embodiment, there is provided an apparatus for bonding at least one die to a substrate , the apparatus comprising: a metrology station within the apparatus, the metrology station comprising at least one sensor , and a bonding station within the apparatus, the bonding station being configured to bond at least one donor substrate to an acceptor substrate, wherein the apparatus is configured to measure initially, using the sensor in the metrology station, at least one characteristic of the at least one donor substrate, a carrier substrate configured to support the at least one donor substrate prior to bonding and/or the acceptor substrate, to bond the at least one donor substrate to the acceptor substrate in the bonding station, and to measure subsequently at least one characteristic of the bonded donor and/or acceptor substrate in the metrology station.

According to an embodiment, there is provided a method of measuring at least one characteristic of a bonded donor and/or acceptor substrate in an apparatus for bonding at least one donor substrate to an acceptor substrate, the method comprising: in a metrology station of the apparatus, measuring initially at least one characteristic of at least one donor substrate, a carrier substrate configured to support the at least one donor substrate prior to bonding and/or an acceptor substrate; in a bonding station of the apparatus, bonding at least one donor substrate to the acceptor substrate; and in the metrology station of the apparatus, measuring subsequently at least one characteristic of the bonded donor and/or acceptor substrate.

According to an embodiment, there is provided a method of configuring an apparatus used in processing semiconductor substrates, the method comprising: obtaining metrology data comprising values of one or more performance parameters associated with a substrate after or before being subject to a process of bonding the substrate to a further substrate using the apparatus described herein; modeling the metrology data to a representation compliant with a control interface of the apparatus; and configuring the apparatus by providing the modeled metrology data to the control interface of the apparatus.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts. The accompanying schematic drawings include the following.
Figures 1A-1D are schematic diagrams illustrating an exemplary die bonding method.
Figure 2 is a schematic diagram illustrating a bonding tool.
Figure 3 is a schematic diagram illustrating an apparatus according to an embodiment of the invention.
Figure 4 is a schematic diagram illustrating movement of acceptor substrates between a metrology station and a bonding station in an apparatus according to an embodiment.
Figures 5A-5D are schematic diagrams showing example alignment marks on a donor substrate and acceptor substrate.
Figures 6A-6C are schematic diagrams showing a measurement/bonding process from a top view, and Figures 7A-7C are schematic diagrams, corresponding to Figures 6A-6C showing the measurement/bonding process from a side view.
Figure 8 is a schematic diagram illustrating movement of acceptor substrates and carrier substrates between a metrology station and a bonding station in an apparatus according to an embodiment

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure.

Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc.

The skilled artisan will appreciate that, in the context of such alternative applications, any use of the terms "wafer" or "die" in this text should be each considered as interchangeable with the more general term "substrate". The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions.

A patterning apparatus (for example, a lithographic apparatus) can comprise, or can form, one or more patterns, which may correspond to one or more die. The patterns can be generated utilizing CAD (computer-aided design) programs, based on a pattern or design layout, this process often being referred to as EDA (electronic design automation).

As used throughout this application "or", unless indicated otherwise, takes a non-exclusive meaning, e.g., encompassing both "and" and "or".

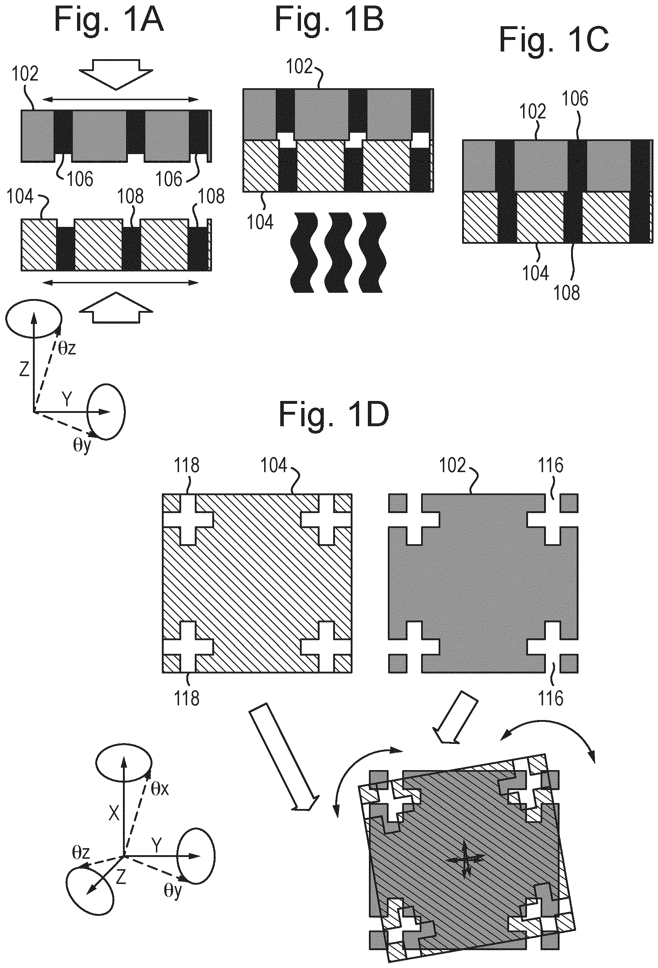

Reference is now made to Figures 1A-1D, which are schematic diagrams illustrating an exemplary die bonding method consistent with embodiments of the present disclosure. The die bonding method comprises bonding one die to another die. As will be appreciated, the bonding technique may be applied to bond any substrate (e.g. a whole wafer, a diced wafer, a partially-diced wafer, a chip, a die, etc.) to any other substrate (e.g. a whole wafer, a diced wafer, a partially-diced wafer, a chip, a die, etc.). For example, the bonding technique may be used to bond a die to another die, where the another die is a part of a wafer.

As shown in Figures 1A-1D, the exemplary die bonding method may involve a donor die 102 and a target die 104. Herein, the term "donor" and the term "target" are used for ease of description. It should be understood that the term "donor" and the term "target" are provided for reference and are relative and that elements described as corresponding to a "donor" can instead correspond to a "target" and vice versa.

The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target die.

The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas or dielectric areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

Figures 1A-1C depict a cross-sectional view of portions of the exemplary die bonding method. As shown in Figure 1A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. As further shown in Figure 1A, the donor die 102 and the target die 104 may be brought together along the z-axis, while the position of the donor die 102 and/or the target die 104 may be adjusted in the x-y plane (e.g., perpendicular to the z-axis of approach). The alignment may be complicated by the multiple layers of the donor die 102 or the multiple layers of the target die 104, which may be optically opaque.

Upon bringing the donor die 102 into contact with the target die 104, an initial bond may be formed between the donor die 102 and the target die 104. The initial bond may be between dielectric areas of the donor die 102 and dielectric areas of the target die 104. The initial bond may comprise intermolecular forces, such as Van der Waal's forces and the like.

As shown in Figure 1B, the donor die 102 and the target die 104 may be annealed after contact. Annealing may be or include heat annealing, electrical annealing, electrostatic processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 and the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole (according to one example for aligning the dies). Alignment marks in the x-y plane of die (e.g., alignment marks 116 on the donor die 102 or alignment marks 118 on the target die 104) may reduce the area available for circuitry. Alignment marks may be additively or subtractively fabricated, such as by etching or deposition in the z-direction.

Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non-zero linewidth portion of the wafer volume when separating die.

The electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the x-axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

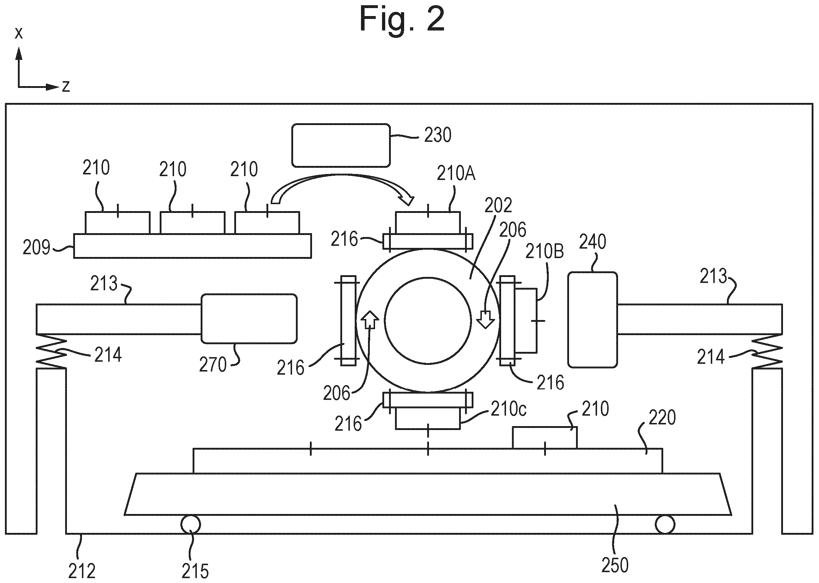

Figure 2 is a schematic diagram illustrating a bonding tool for the placement of donor substrates 210 onto an acceptor substrate 220 by a moveable stage 202. Figure 2 is described with reference to "donor" substrates 210 (e.g. donor substrates 210A-210C) and "acceptor" substrates 220, which are relative descriptors - a donor substrate may instead be an acceptor substrate, and vice-versa. The bonding tool depicted in Figure 2 may be configured to place any donor substrate (e.g. a whole wafer, a diced wafer, a partially-diced wafer, a chip, a die, etc.) onto any target substrate (e.g. a whole wafer, a diced wafer, a partially-diced wafer, a chip, a die, etc.). For example (and as depicted in Figure 2), the bonding tool may be configured to place a donor die 210 onto an acceptor wafer 220.

The acceptor substrate 220 may comprise one or more target portions. For example, the acceptor substrate 220 may comprise one or more target dies formed therein (prior to being diced/separated). The method/apparatus depicted in Figure 2 may be to place a donor die 210 onto a target die of the acceptor wafer 220. In the case that the acceptor wafer 220 comprises a plurality of target dies, the method may be repeated such that each donor die 210 is placed onto one of the plurality of target dies on the acceptor wafer 220.

The placing of a donor substrate 210 onto an acceptor substrate 220 may be a part of a bonding process comprising bonding the donor substrate 210 and the acceptor substrate 220 together. The bonding between the donor substrate 210 and the acceptor substrate 220 may be the same, or similar to, the bonding described with reference to Figure 1.

The stage 202 may be substantially circular in the x-z plane, with a longitudinal axis along the y-direction (e.g. the stage 202 may be substantially cylindrical in three dimensions). The stage 202 may instead have a different cross-sectional shape, such as square, hexagonal, etc. The stage 202 may have a symmetrical (e.g., as shown) cross-section with one or more axis of symmetry, or asymmetrical cross-sectional area (for example, an irregular polygon).

The stage 202 may comprise receiver portions 216. The receiver portions 216 each may be, or may comprise, a recess. The receiver portions 216 may each be configured to receive and/or accept and/or support and/or hold and/or clamp a donor substrate 210. The receiver portions 216 may each be configured to clamp a donor substrate 210 thereto using a vacuum clamping means and/or an electrostatic clamping means.

The placement of the receiver portions 216 may be symmetrical or asymmetrical around the cross-sectional area of the stage 202. The stage 202 may have a substantially symmetrical cross-section but have asymmetric placement of receiver portions 216. For example, the stage 202 may have a cross-section that is a regular hexagon but have receiver portions 216 placed asymmetrically along longitudinal faces.

The stage 202 may be a moveable stage, e.g. a rotatable stage. The stage 202 may be controllably moved (e.g. rotated) in a direction 206 about the longitudinal axis. The direction 206 is provided as an example. The stage 202 may instead be rotated in an opposite direction or any appropriate direction, translated along the x, y, or z direction or any combination thereof. The stage 202 may be operated in both rotational and translational modes, including sequentially or at the same time. For example, the stage 202 may move in the negative x-direction towards a support structure 250 while also rotating about the longitudinal axis. The stage 202 may move continuously or intermittently. For example, the stage 202 may rotate in the direction 206 and stop at four (or fewer or more) positions corresponding to operations in the placement of the donor substrate 210.

Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the stage 202 is substantially zero), but the positions may instead correspond to continuous (or quasi-continuous movement) or operations may occur while the stage 202 is moving in one or more directions (e.g., rotationally, translationally, etc.).

A first position, such as corresponding to the position depicted for the donor substrate 210A, may correspond to placement of a donor substrate 210A in a receiver portion 216 of the stage 202. The donor substrate 210A may be placed on the receiver portion 216 by a pick and place element 230. The pick and place element 230 may place the donor substrate 210A on the stage 202 on the receiver portion 216 based on alignment information, based on positional information of the stage 202, etc. The pick and place element 230 may place the donor substrate 210A on the support structure at a given position relative to the receiver portion 216. For example, the pick and place element 230 may center the donor substrate 210A relative to the receiver portion 216.

The second position, such as corresponding to the position depicted for the donor substrate 210B, may correspond to measurement of the position of the donor substrate 210B relative to the receiver portion 216 of the stage 202. The position (e.g., location) of the donor substrate 210B may be measured by a location measurement element 240. The location measurement element 240 may measure an actual position of the donor substrate 210B, in relative (such as relative to the receiver portion 216) or absolute terms (such as in distances from an origin point on the stage 202, on the location measurement element 240, etc.).

The location measurement element 240 may be a camera, e.g., a two-dimensional camera, two or more one-dimensional cameras, an optical camera, etc., or another measurement device. The location measurement element 240 may be made up of multiple location measurement elements, such as an in-plane measurement device which may measure locations in the x-y plane (relative to the reference axes) and an out-of-plane measurement device which may measure locations or distances in the z direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the stage 202.

Once the position of the donor substrate 210B is measured, the stage 202 may move (e.g., rotate in the direction 206), so that the donor substrate 210B occupies the position of the donor substrate 210C, which may be a third position of the stage 202. The third position of the support structure will now be described with reference to the donor substrate 210C.

The third position, such as corresponding to the position depicted for the donor substrate 210C, may correspond to placement of the donor substrate 210C on the acceptor substrate 220. The acceptor substrate 220 may comprise a target portion (e.g. a target die, as described above). The bonding tool may be configured to place the donor substrate 210C at the target portion of the acceptor substrate 220 by bringing the donor substrate 210C into contact with the target portion of the acceptor substrate 220. As the donor substrate 210C is brought into contact with the target portion of the acceptor substrate 220, initial bonding forces (e.g. Van der Waal's forces and the like) may be formed between the donor substrate 210C and the acceptor substrate 220.

The acceptor substrate 220 may be supported by the support structure 250. The donor substrate 210C may be brought into contact with the acceptor portion by motion of the stage 202 towards the support structure 250, motion of the support structure 250 towards the stage 202, or a combination thereof. Motion of the stage 202 towards the support structure 250 may comprise movement in the z-direction. Motion of the stage 202 towards the support structure 250 may comprise movement of the whole stage 202 towards the support structure 250. Motion of the stage 202 towards the support structure 250 may comprise a combination of movement of the whole stage 202 and movement of the receiver portion 216 in the third position relative to the main body of the stage 202. Motion of the support structure 250 towards the stage may comprise movement in the z-direction.

Once the donor substrate 210C is placed on the acceptor substrate 220, the stage 202 and the support structure 250 may operate (individually or in concert) to place at least one additional donor substrates on the acceptor substrate 220. For example, the stage 202 and the support structure 250 may move relative to one another in the x- or y-direction so that another part of the acceptor substrate 220 is proximate to the stage 202 (e.g. so that another target portion of the acceptor substrate 220 is aligned with the stage 202). The relative motion of the stage 202 and the support structure 250 may be caused by movement of the support structure 250 (e.g. by the positioning system for the support structure 250).

After placing the donor substrate 210C onto the acceptor substrate 220, the stage 202 may rotate to align the next donor substrate on the stage (i.e. the donor substrate 210B) with the acceptor substrate 210. Generally, the stage 202 may be rotatable to align different donor substrate 210 (and/or different receiver portions 216 of the plurality of receiver portions 216) with the acceptor substrate 220.

A direction of gravity is not depicted, but the placement of the donor substrate 210C on the acceptor substrate 220 may experience gravitation effects. For example, the placement of the donor substrate 210C on the acceptor substrate 220 may be encouraged by gravity (e.g., occur in the direction of gravity) or be retarded by gravity (e.g., occur opposite the direction of gravity). Gravitational effects may be balanced by clamps, suction, vacuum, and other forces.

The stage 202 may comprise an actuator (not shown). The actuator may be configured to cause the stage 202 to accept the donor substrates 210 from the pick & place element 230 and subsequently transport the donor substrates 210 to location measurement element 240 and finally place the donor substrates 210 on the acceptor substrate 220. The actuator may be configured to rotate the stage 202 in the manner described above.

The support structure 250 may be configured to move the acceptor substrate 220 with high accuracy. The bonding tool may comprise a base frame 212. As shown in Figure 2, the support structure 250 that supports the acceptor substrate 220 may be coupled to the base frame 212 by at least one bearing 215. The support structure 250 may comprise a plurality of stages that may be stacked relative to each other via a plurality of bearings.

For example, the support structure 250 may comprise a long stroke module for relatively coarse positioning of the acceptor substrate 220 over a longer distance, and a short stroke module for higher accuracy positioning of the acceptor substrate 220 over a shorter distance. The short stroke module may be stacked on the long stroke module. The short stroke module and the long stroke module may each be part of a positioning system configured to position the support structure 250 (and therefore to position the acceptor substrate 220 supported on the support structure 250) in the horizontal plane, i.e. in the x- and y-directions. The short stroke module and the long stroke module may each comprise one or more actuators configured to move the support structure 250 relative to the base frame 212. Thus, in general, the positioning system may comprise one or more actuators configured to move the support structure 250.

The positioning system may comprise one or more sensors configured to determine the position of the support structure. The one or more sensors may be interferometric sensors, as described in US5477057 A, the entirety of which is hereby incorporated by reference.

As shown in Figure 2, the bonding tool may comprise a frame 213. The frame 213 may be referred to as an isolated frame. The frame 213 may be isolated relative to the base frame 212. The bonding tool may comprise an isolator 214. The isolator 214 may be configured to substantially isolate the frame 213 from the base frame 212. By isolating the frame 213 from the base frame 212, vibrations of the base frame 212 may have less of an effect on the frame 213.

A controller may be configured to control the stage 202 and the support structure 250 so as to accurately place a donor substrate 210 onto a target portion of the acceptor substrate 220. Alignment between the donor substrate 210 and the acceptor substrate 220 in the horizontal (x and y) directions is important. This is because, as described above, the donor substrate 210 and the acceptor substrate 220 each have electrically-active areas which must come into contact with each other for the combination of the donor substrate 210 and the acceptor substrate 220 to function as intended.

The position of the stage 202 (e.g. the position of the receiver portion 216 in the third position) relative to the support structure 250 may be determined by measuring the position of the stage 202 using one measurement system, and measuring the position of the support structure 250 using another, independent measurement system (e.g. the positioning system described above). The positions of the stage 202 and the support structure 250 may be measured in different coordinate systems, and/or with respect to different references.

For the bonding tool to be able to accurately place a donor substrate 210 at a target portion of the acceptor substrate 220, the relative position of the support structure 250 and the stage 220 may need to be accurately determined based on the measured position of the stage 202 and/or the measured position of the support structure 250 (specifically, in the x- and y-directions). In some embodiments, the position of the stage 202 in the x- and y-directions may be fixed, such that the determination of the position of the stage 202 relative to the support structure 250 in the x- and y-directions is based on the measurement of the position of the support structure 250 by the positioning system. Even where the position of the stage 202 in the x- and y-directions is fixed, the stage 202 may be able to rotate to align different receiver portions 216 with the acceptor substrate 220.

To accurately align the donor substrate 210 and the acceptor substrate 220, the position of the donor substrate 210 relative to the acceptor substrate 220 may be determined. The determination of the position of the donor substrate 210 relative to the acceptor substrate 220 may be direct, indirect, explicit or implicit. For example, the actual position of the donor substrate 210 relative to the acceptor substrate 220 itself may not be explicitly determined, but another parameter which is indicative of the position of the donor substrate 210 relative to the acceptor substrate 220 may be determined (and thus the position of the donor substrate 210 relative to the acceptor substrate 220 is determined indirectly/implicitly). The determination of the position of the donor substrate 210 relative to the acceptor substrate 220 may be may be done with use of alignment marks (e.g. like the alignment marks 118, 116 depicted in Figure 1) on the donor substrate 210 and the acceptor substrate 220.

Additionally or alternatively, the position of the donor substrate 210 relative to the acceptor substrate 220 may be determined based on determining the position of the stage 202 (e.g. the position of the receiver portion 216 in the third position) relative to the support structure 250. This may be possible because the position of the acceptor substrate 220 relative to the support structure 250 is accurately known and/or the position of the donor substrate 210 relative to the stage 202 (e.g. relative to the receiver portion 216) is accurately known. The position of the receiver portion 216 in the third portion relative to the stage 202 in general may be known and fixed (e.g. because the receiver portion 216 is fixedly coupled to a main body of the stage 202). Thus, knowledge of the position of the stage 202 relative to the support structure 250 may be equivalent to knowledge of the position of the receiver portion 216 in the third position relative to the support structure, and vice-versa.

The position of the donor substrate 210 relative to the stage 202 (e.g. relative to the receiver portion 216) may be accurately known through measurements performed by the location measurement element 240, as described above.

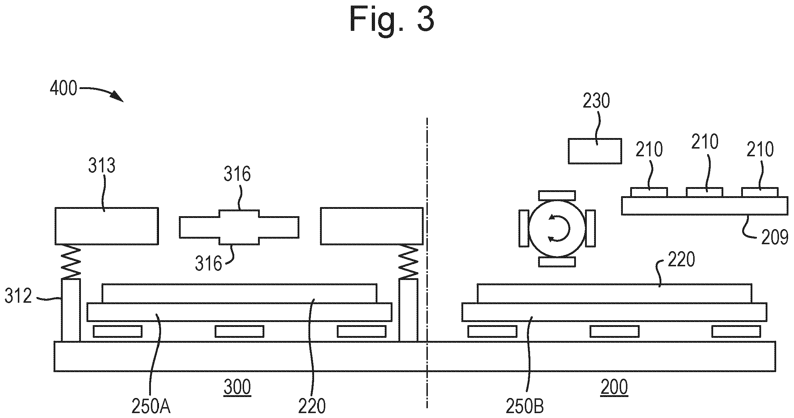

The position of the acceptor substrate 220 relative to the support structure 250 may be known through a metrology process performed by a sensor, e.g. an alignment sensor. The alignment sensor used to obtain the position of the acceptor substrate 220 relative to the support structure 250 may be known may be an interferometric sensor. The alignment sensor may be configured to determine a position of an alignment mark (e.g. a diffraction grating) on the acceptor substrate 220 relative to a reference mark (e.g. a diffraction grating) on the support structure 250. An example of an alignment sensor is described in EP1 372 040B1, the entirety of which is hereby incorporated by reference. The alignment sensor may be disposed in a metrology station (which may otherwise be referred to as a measurement station) of the apparatus comprising the bonding tool. For example, alignment sensor 316 may be used, as described below in relation to figure 3.

In known scanners for exposing a substrate, optimisation of the throughput of the apparatus may be limited by the time needed for exposure. Thus, the measurement related processes carried out in the metrology station (e.g. loading a substrate, measuring the position of a substrate support, obtaining a level map, determining alignment of the substrate on the substrate support and swapping any substrate supports) should ideally be carried out within the time taken for exposure. In general, offsets which contribute to overlay in scanners are typically corrected outside the apparatus, for instance using feedback of a process loop in which overlay measurements are used to determine offset parameters. Such offsets which can be corrected in this way might include (i) mark-to-mark offset fingerprint that remains largely constant over time (e.g. mask deformations) and/or (ii) lower-order, slowly-drifting offsets. The overlay is typically measured using dedicated equipment outside of the apparatus.

In known systems, deformation correction of a donor substrate for feedforward correction for die to wafer bonding (i.e. donor substrate to acceptor substrate bonding) is not measured in-situ or outside.

In the die-to-wafer bonding machine die deformation can be expected to occur for various reasons, such as, processes before bonding (e.g. dicing etc), process adjustment in the factory, insufficient (or non existing) correction with mask writing or in-scanner loop. If we follow the correction loops of a standard scanner, these parameters can be measured externally by dedicated scanner or metrology equipment outside of the apparatus. However, it can take a substantial amount of time for the relevant data to be available. Thus, the presently known systems typically take a long time for providing feedback data and require a separate machine (which increases costs).

Stand-alone metrology station may use an alignment sensor to measure multiple alignment marks; the sampling scheme of such a tool can be optimized to measure both the intradie deformation and global wafer deformation at the same time. However, such stand-alone stations are expected to be very expensive for various reasons, such as literal additional space taken up by such a stand-alone station and the time used for carrying out the measurements which add to cycle time.

The time it takes to fill a wafer with bonded dies is expected to be substantially longer than the time needed for exposure of a wafer in today's scanner. The present inventors have identified that additional measurements could be carried out to make better use of the metrology tool already available in an apparatus for bonding. In particular, the present invention proposes to use at least one sensor (e.g. the alignment sensor 316) at the measure side of the apparatus for measurement (e.g. deformation measurement) of the donor substrate(s) and/or acceptor substrate after bonding.

According to the present invention, an apparatus is provided for bonding at least one die to a substrate. The apparatus comprises a metrology station and a bonding station within the apparatus, e.g. as depicted in Figure 3. The bonding station 200 may comprise some or all of the features of the bonding tool described above (e.g. in relation to Figure 2). The metrology station 300 is separate and/or distinct from the bonding station 200 (i.e. the station depicted in Figure 2).

The metrology station 300 comprises at least one alignment sensor 316, (e.g. as described above). The apparatus 400 is configured to measure initially, using the alignment sensor 316 in the metrology station 300, at least one characteristic of the at least one donor substrate 210, and/or to measure at least one characteristic of a carrier substrate 209 configured to support the at least one donor 210 substrate prior to bonding and/or to measure at least one characteristic of the acceptor substrate 220. The initial measurement may otherwise be referred to as pre-bonding measuring. The initial measurement may be used to determine characteristics of the substrates, e.g. of the donor substrate, carrier substrate and/or acceptor substrate before bonding. The apparatus 400 is configured to bond the at least one donor substrate to the acceptor substrate in the bonding station 200 (for example, as described above). The apparatus 400 is configured to measure subsequently at least one characteristic of the bonded donor and/or acceptor substrate (which may otherwise be referred to as a bonded substrate) in the metrology station 300. Thus, the apparatus 400 is configured to measure the bonded substrate within the apparatus 400.

Thus, the metrology station 300 can be used for measuring position feedback directly after bonding. Instead of unloading the bonded donor substrate and acceptor substrate, the substrate support (which may otherwise be referred to as a chuck and/or substrate table and/or wafer table) with the bonded donor substrate and acceptor substrate is kept at the measure side. Alignment marks can be measured, e.g. to establish the intra-die deformation and/or the die-to-die placement error. This information can be used to provide post-bonding overlay data to the user and/or directly to compensate, in the apparatus 400, for drift in correctible bonding overlay parameters, e.g. translation offset, magnification, rotation, etc.. Because the measurement is done immediately after bonding (preferably within at least a few minutes), this information is available much quicker than if an external metrology tool (e.g. for overlay and/or alignment) is used. Given the sequence of measurements, the correction can be available for the n+2 wafer (the n+1 wafer is being bonded during the verification readout).

As shown in Figure 3, the metrology station 300 may comprise a metrology frame 313. The metrology frame 313 may be referred to as an isolated frame. The metrology frame 313 may be isolated relative to the base frame 312. The metrology station 300 may comprise an isolator 314. The isolator 314 may be configured to substantially isolate the metrology frame 313 from the base frame 312. By isolating the metrology frame 313 from the base frame 312, vibrations of the base frame 312 may have less of an effect on the metrology frame 313.

Although not shown in Figure 3, the bonding station 200 may comprise a frame 213 and/or base frame 212 and/or isolator 214 as described in relation to Figure 2.

Generally, the apparatus 400 is configured to move the donor substrate from the metrology station 300 to the bonding station 200. The donor substrate may be provided on the carrier substrate prior to bonding. Thus, the donor substrate and the carrier substrate may be moved together prior to bonding. The donor substrate and the carrier substrate may be supported on the same support structure (at least until the donor substrate is moved from the acceptor substrate to the acceptor substrate in the bonding process). Generally, the apparatus 400 is configured to move the acceptor substrate from the metrology station 300 to the bonding station 200. Generally, the apparatus 400 is configured to move the bonded donor and acceptor substrate from the bonding station 200 to the metrology station 300. Thus, the bonded donor substrate and acceptor substrate are moved together after bonding (as they are fixed together in the bonding process). The bonded donor substrate and acceptor substrate are supported on the same support structure.

The apparatus 400 may comprise at least two support structures 250, each configured to support an acceptor substrate 220. The support structures 250 may be independently moveable. The support structures 250 may each be provided with a positioning system, such as the positioning system described above. Alternatively, the bonding tool may comprise a single positioning system which is configured to move the two support structures 250 independently. The apparatus 400 may comprise a first substrate support structure 250A and a second substrate support structure 250B, wherein each substrate support structure is configured to move between at least the metrology station 300 and the bonding station 200.

The apparatus 400 may be configured such that one of the first substrate support structure 250A and the second substrate support structure 250B can be positioned in the metrology station 300 and the other of the first substrate support structure 250A and the second substrate support structure 250B can be positioned in the bonding station 200, simultaneously.

In the present embodiment, the apparatus 400 is configured to carry out simultaneously the initial measuring and the bonding. Thus, preparatory measurement processes may be performed on one acceptor substrate 220 (in the metrology station 300) while bonding processes are performed on another acceptor substrate 220 (in the bonding station 200). It is noted that bonding time (per carrier substrate and/or acceptor substrate) may be, for example, of the order of a few minutes, for example 2 to 5 minutes, and the metrology station 300 may be configured to carry out multiple measurement (e.g. of a mark) per second, for example, of the order of tens of measurements per second, for example 5 to 30 marks per second. For comparison only (and ignoring time for moving supports and/or swapping substrates), there could be of the order of hundreds or thousands of measurements (e.g. mark readouts) during the bonding process on one acceptor substrate and/or carrier substrate.

In the present embodiment, the apparatus 400 is configured to carry out simultaneously the bonding and the subsequent measuring. Thus, post-bonding measurement processes may be performed on one acceptor substrate 220 (in the metrology station 300) while bonding processes are performed on another acceptor substrate 220 (in the bonding station 200).

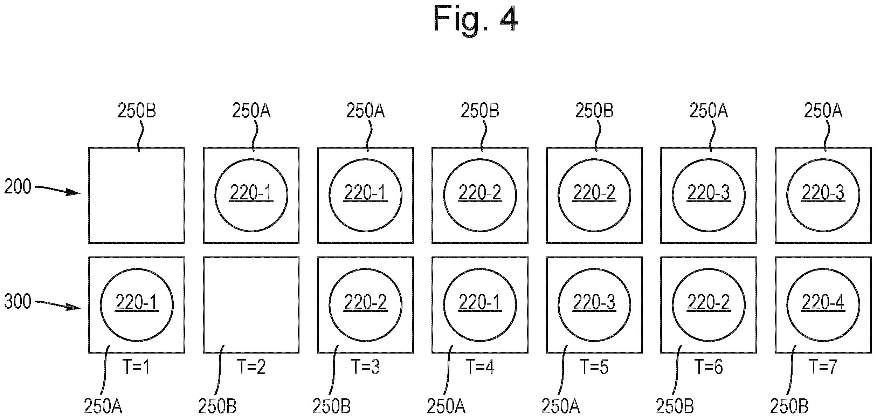

Thus, in line with the above, the apparatus 400 is configured to receive a first acceptor substrate, carry out initial measurement processes, subsequently carry out bonding processes and subsequently carry out post-bond measurements on the first acceptor substrate. The apparatus 400 is configured to receive a second acceptor substrate (a further acceptor substrate), and to carry out the same process including initial measurement of at least one characteristic of the second acceptor substrate, bonding and post-bond measurement. The processing of the first and second acceptor substrates can be staggered so as to allow for simultaneous processing steps to be carried out on each of the acceptor substrates in different stations at the same time. The apparatus 400 is configured to process additional acceptor substrates also, and the processing of each additional substrate can be staggered. This is described by way of the example shown in Figure 4.

In Figure 4, different stages of the process are indicated by different time blocks, for example, T=1, T=2, T=3, etc.. Each time block represents a specific amount of time. A process which requires more than the specific amount of time represented by one time block is shown in two or more consecutive time blocks. A process shown in two consecutive time blocks may be a continual process (i.e. there may be no specific change or shift in the process between the first and second time block). The process shown in any given time block may not require a full time block. The acceptor substrates are labelled in Figure 4 as a first acceptor substrate 220-1, a second acceptor substrate 220-2, a third acceptor substrate 220-3 and a fourth acceptor substrate 220-4. It will be understood that further processes can be carried out and additional substrates can be processed.

In Figure 4, at T=1, the first acceptor substrate 220-1 may be loaded into the metrology station 300, preferably onto a first substrate support structure 250A. At least one characteristic of the first acceptor substrate 220-1 is measured in the metrology station 300. In particular, the metrology station 300 may be configured to measure the position of an alignment mark (e.g. a diffraction grating) on the first acceptor substrate 220-1 and/or the first substrate support structure 250A. In particular, the measurement may be used to determine the position of the first acceptor substrate 220-1 on the first substrate support structure 250A. The measurement may include any appropriate measurement, such as alignment measurement, overlay measurement, height measurement, etc.. The metrology station 300 may be configured at least to measure multiple alignment marks relating to the first acceptor substrate 220-1. The apparatus may be configured to use the measurements in various ways. For example, a possible use of multiple alignment marks may be determining deviations between expected position of alignment marks on the first acceptor substrate 220-1 with respect to expected positions. There is an expectation of the location of the alignment mark based on the illumination pattern and the design of the structures on the first acceptor substrate 220-1. Such deviations can be the result of deformations of the first acceptor substrate 220-1 and/or inaccuracies of the tool that manufactured the structures (including the lithographic tool that illuminated the structure pattern on the acceptor substrate 220-1). Knowing such deformations of the first acceptor substrate 220-1 may also be taken into account when bonding at least one donor substrate to the first acceptor substrate 220-1. The same measurements and/or determinations may be useful when measuring any other substrates (such as a donor substrate and/or carrier substrate and/or further acceptor substrate). At T=1 may be referred to as an initial measurement (or alignment) step.

When the measurements have been carried out, the first substrate support structure 250A, on which the first acceptor substrate 220-1 is held, is moved to the bonding station 200, i.e. the apparatus 400 is configured to move the first acceptor substrate 220-1 from the metrology station 300 to the bonding station 200 by the start of T=2. It will be noted that at substantially the same time, the second support structure 250B (which may not hold a substrate initially) is moved to the metrology station 300. The first substrate support structure 250A and the second substrate support structure 250B may effectively swap positions.

At T-2, bonding of at least one donor substrate to the first acceptor substrate 220-1 is carried out in the bonding station 200.

At T=3, the apparatus 400 is configured to receive the second acceptor substrate 220-2 in the metrology station 300. Whilst bonding of the at least one donor substrate to the first acceptor substrate 220-1 is carried out (i.e. continued from T=2), the second acceptor substrate 220-2 may be loaded into the metrology station 300, preferably onto the second support structure 250B. At least one characteristic of the second acceptor substrate 220-2 is measured in the metrology station 300. In particular, the metrology station 300 may be configured to measure the position of an alignment mark (e.g. a diffraction grating) on the second acceptor substrate 220-2 and/or the second substrate support structure 250B. In particular, the measurement may be used to determine the position of the second acceptor substrate 220-2 on the second substrate support structure 250B. The measurement may include any appropriate measurement, such as alignment measurement, overlay measurement, height measurement, etc.. The metrology station 300 may be configured at least to measure multiple alignment marks relating to the second acceptor substrate 220-2. The apparatus may be configured to use the measurements in various ways. For example, a possible use of multiple alignment marks may be determining deviations between expected position of alignment marks on the second acceptor substrate 220-2 with respect to expected positions. There is an expectation of the location of the alignment mark based on the illumination pattern and the design of the structures on the second acceptor substrate 220-2. Such deviations can be the result of deformations of the second acceptor substrate 220-2 and/or inaccuracies of the tool that manufactured the structures (including the lithographic tool that illuminated the structure pattern on the second acceptor substrate 220-2). Knowing such deformations of the second acceptor substrate 220-2 may also be taken into account when bonding at least one donor substrate to the second acceptor substrate 220-2. The same measurements and/or determinations may be useful when measuring any other substrates (such as a donor substrate and/or carrier substrate and/or further acceptor substrate). At T=3 may be referred to as an initial measurement (or alignment) step.

Thus, the apparatus 400 is configured to measure at least one characteristic of the second acceptor substrate whilst simultaneously bonding at least one die to the first acceptor substrate. When bonding of the at least one donor substrate to the first acceptor substrate 220-1 is complete, the bonded donor substrate and first acceptor substrate 220-1 may be referred to as the first bonded substrate.

When the initial measurements of the second acceptor substrate 220-2 and bonding to the first acceptor substrate 220-1 have been carried out (i.e. by the end of T=3), the first substrate support structure 250A, on which the bonded donor substrate and first acceptor substrate 220-1 are held, is moved to the metrology station 300, i.e. the apparatus 400 is configured to move the bonded die and first acceptor substrate 220-1 from the bonding station 200 to the metrology station 300 by the start of T=4. The second support structure 250B on which the second acceptor substrate 220-2 is held is moved to the bonding station 200, i.e. the apparatus 400 is configured to move the second acceptor substrate 220-2 from the metrology station 300 to the bonding station 200 by the start of T=4. The first and second substrate supports 250A and 250B may be moved at substantially the same time. The first substrate support structure 250A and the second substrate support structure 250B may effectively swap positions.

At T=4, at least one characteristic of the bonded donor substrate and/or first acceptor substrate 220-1 is measured in the metrology station 300. In particular, the metrology station may be configured to measure the position of an alignment mark (e.g. a diffraction grating) on the bonded donor substrate and first acceptor substrate 220-1 (i.e. on the first bonded donor substrate(s) and/or on the first acceptor substrate bonded to the first donor substrate(s)). In particular, the measurement may be used to determine the position of the first bonded donor substrate(s) on the first acceptor substrate when bonded. The measurement may include any appropriate measurement, such as alignment measurement, overlay measurement, height measurement, etc.. The metrology station 300 may be configured at least to measure multiple alignment marks relating to any/all bonded donor substrates and/or the bonded first acceptor substrate 220-1. The apparatus may be configured to use the measurements in various ways. For example, a possible use of multiple alignment marks may be determining deviations between expected position of alignment marks on the bonded donor substrate(s) and/or on the bonded acceptor substrate 220-1 with respect to expected positions. There is an expectation of the location of the alignment mark based on the illumination pattern and the design of the structures on the acceptor substrate 220-1 and/or expected bonding location. Such deviations can be the result of deformations of the acceptor substrate 220-1 and/or inaccuracies of the tool that manufactured the structures (including the lithographic tool that illuminated the structure pattern on the acceptor substrate 220-1) and/or deformation introduced during bonding. Knowing such deformations of bonded donor substrates and/or the bonded first acceptor substrate may also be taken into account when bonding at least one donor substrate to the any further acceptor substrates

(e.g. the second acceptor substrate 220-2 and/or third acceptor substrate 220-3 etc.). The same measurements and/or determinations may be useful when measuring any other substrates (such as any further bonded substrates). At T=4 may be referred to as a subsequent measurement (or post-bond measurement or verification) step.

Also at T=4, bonding of at least one donor substrate to the second acceptor substrate 220-2 is carried out in the bonding station 200. In other words, the apparatus 400 is configured to measure at least one characteristic of the bonded donor substrate and first acceptor substrate 220-1 whilst simultaneously bonding at least one donor substrate to the second acceptor substrate 220-2.

When the relevant measurements have been carried out on the bonded donor substrate and first acceptor substrate 220-1, the bonded donor substrate and first acceptor substrate 220-1 can be unloaded from the first substrate support structure 250A.

At T=5, the apparatus 400 is configured to receive a third acceptor substrate 220-3 in the metrology station 300. Whilst bonding of at least one donor substrate to the second acceptor substrate 220-2 is carried out (i.e. continued from T=4), the third acceptor substrate may be loaded into the metrology station 300, preferably onto the first support structure 250A. At least one characteristic of the third acceptor substrate 220-3 is measured in the metrology station 300. In particular, the metrology station 300 may be configured to measure the position of an alignment mark (e.g. a diffraction grating) on the third acceptor substrate 220-3 and/or the first substrate support structure 250A. In particular, the measurement may be used to determine the position of the third acceptor substrate 220-3 on the first substrate support structure 250A. The measurement may include any appropriate measurement, such as alignment measurement, overlay measurement, height measurement, etc.. The metrology station 300 may be configured at least to measure multiple alignment marks relating to the third acceptor substrate 220-3 and/or use the measurements as described above in relation to the first and/or second acceptor substrates. At T=5 may be referred to as an initial measurement (or alignment) step.

Thus, the apparatus 400 is configured to measure at least one characteristic of the third acceptor substrate 220-3 whilst simultaneously bonding at least one donor substrate to the second acceptor substrate 220-2. When bonding of the at least one donor substrate to the second acceptor substrate 220-2 is complete, the bonded donor substrate and second acceptor substrate 220-2 may be referred to as the second bonded substrate.

When the initial measurements of the third acceptor substrate 220-3 and bonding to the second acceptor substrate 220-2 have been carried out (i.e. by the end of T=5), the second substrate support structure 250B, on which the bonded donor substrate and second acceptor substrate 220-2 are held, is moved to the metrology station 300, i.e. the apparatus 400 is configured to move the bonded die and second acceptor substrate 220-2 from the bonding station 200 to the metrology station 300 by the start of T=6. The first support structure 250A on which the third acceptor substrate 220-3 is held is moved to the bonding station 200, i.e. the apparatus 400 is configured to move the third acceptor substrate 220-3 from the metrology station 300 to the bonding station 200 by the start of T=6. The first and second substrate supports 250A and 250B may be moved at substantially the same time. The first substrate support structure 250A and the second substrate support structure 250B may effectively swap positions.

At T=6, at least one characteristic of the bonded donor substrate and/or second acceptor substrate 220-2 is measured in the metrology station 300. In particular, the metrology station may be configured to measure the position of an alignment mark (e.g. a diffraction grating) on the bonded donor substrate and second acceptor substrate 220-2 (i.e. on the second bonded donor substrate(s) and/or on the second acceptor substrate bonded to the first donor substrate(s)). In particular, the measurement may be used to determine the position of the second bonded donor substrate(s) on the second acceptor substrate when bonded. The measurement may include any appropriate measurement, such as alignment measurement, overlay measurement, height measurement, etc.. The metrology station 300 may be configured at least to measure multiple alignment marks relating to any/all bonded donor substrates and/or the bonded second acceptor substrate 220-2 and/or use the measurements as described above in relation to the bonded donor substrates and/or the bonded first acceptor substrate 220-1. At T=6 may be referred to as a subsequent measurement (or post-bond measurement or verification) step.

Also at T=6, bonding of at least one donor substrate to the third acceptor substrate 220-3 is carried out in the bonding station 200. In other words, the apparatus 400 is configured to measure at least one characteristic of the bonded donor substrate and second acceptor substrate 220-2 whilst simultaneously bonding at least one donor substrate to the third acceptor substrate 220-3.

When the relevant measurements have been carried out on the bonded donor substrate and second acceptor substrate 220-2, the bonded donor substrate and second acceptor substrate 220-2 can be unloaded from the second substrate support structure 250A.

At T=7, the apparatus 400 is configured to receive a fourth acceptor substrate 220-4 in the metrology station 300. Whilst bonding of at least one donor substrate to the third acceptor substrate 220-3 is carried out (i.e. continued from T=6), the fourth acceptor substrate 220-4 may be loaded into the metrology station 300, preferably onto the second support structure 250B. At least one characteristic of the fourth acceptor substrate 220-4 is measured in the metrology station 300. In particular, the metrology station 300 may be configured to measure the position of an alignment mark (e.g. a diffraction grating) on the fourth acceptor substrate 220-4 and/or the second substrate support structure 250B. In particular, the measurement may be used to determine the position of the fourth acceptor substrate 220-4 on the second substrate support structure 250B. The measurement may include any appropriate measurement, such as alignment measurement, overlay measurement, height measurement, etc.. The metrology station 300 may be configured at least to measure multiple alignment marks relating to the fourth acceptor substrate 220-4 and/or use the measurements as described above in relation to the first and/or second acceptor substrates. At T=7 may be referred to as an initial measurement (or alignment) step.

Thus, the apparatus 400 is configured to measure at least one characteristic of the fourth acceptor substrate 220-4 whilst simultaneously bonding at least one donor substrate to the third acceptor substrate 220-3. When bonding of the at least one donor substrate to the third acceptor substrate 220-3 is complete, the bonded donor substrate and third acceptor substrate 220-3 may be referred to as the third bonded substrate.

As will be understood, the sequence of processes shown in Figure 4 can be continued to finish bonding and subsequent measuring of at least the third substrate 220-3 and the fourth substrate 220-4 and any further substrates. The process can be repeated to continually receive and process substrates. When multiple substrates are being processed, the metrology station 300 can alternate between measuring an acceptor substrate about to be bonded, and measuring an acceptor substrate which has just been bonded.

Because the post-bond measurement (i.e. subsequent measurement) can be done immediately after bonding (e.g. within the minutes following bonding), this information is available much quicker than if an external metrology tool is used.

The apparatus 400 may be configured to use feedback from the measurement of the bonded die and/or acceptor substrate to adjust at least one setting in the bonding station 200. Given the sequence of measurements, adjustments (e.g. corrections) can be available for the n+2 substrate (for example, if the n+1 substrate is being bonded during the verification readout). For example, the measurements taken of the bonded donor substrate and first acceptor substrate in T=4 can be used for making adjustments during bonding of the third acceptor substrate in T=6. It is noted that feedforward may be done faster, and depending on the specific time schedules / lead times for measuring and bonding, feedforward for the n+1 substrate may also be implemented in the apparatus. Thus, the feedback from the measurement of the bonded die and/or acceptor substrate can be used for any subsequent bonding, even bonding of the next (i.e. successive) substrate being processed in the apparatus.

It is described that a donor substrate, or at least one donor substrate is bonded to an acceptor substrate. It will be understood that any reference to a donor substrate or at least one donor substrate may mean multiple donor substrates. It is noted that the time taken for bonding multiple substrates may be longer than the time taken to carry out any given measurement and so bonding multiple donor substrates to any given acceptor substrate provides sufficient time for both the initial measuring and subsequent measuring (i.e. the pre and post measuring). For example only, multiple donor substrates may be bonded to the second acceptor substrate 220-2 (in T=4&5 above) which provides sufficient time for receiving the first acceptor substrate 220-1 in the metrology station 300, carrying out the post-bond measurements on the bonded first acceptor substrate 220-1, unloading the bonded first acceptor substrate 220-1, receiving the third acceptor substrate 220-3, and carrying out the pre-bond measurements on the third acceptor substrate 220-3. If only one donor substrate were to be bonded to the acceptor substrate, the bonding may still take longer than several measurements and so may allow for enough measurements to be taken during bonding only a single substrate. Carrying out a greater number of measurements (which could be tens, or hundreds or even thousands of measurements) may take slightly longer than the bonding time if only a single, or a small number of donor substrates are bonded. Ultimately, the amount of time for bonding, pre-bond measurements and post-bond measurements may be predicted based on known estimated times and so the overall processes can be optimised depending on how long each part of the process is likely to take. In further detail, the total bonding time (and thus, the time available for measurement) may scale linearly with the number of donor substrates to be bonded. The time available for measurements may be used in any way appropriate, e.g. to carry out measurement relevant to determining corrections and/or to take measurements that benefit the full-substrate model more.

Two time blocks roughly represent the time for bonding, and a single time block represents the time to carry out post bond measurements, and single time block roughly represents the time to carry out pre-bond measurements. In these time blocks, the substrates may also be loaded, unloaded and/or moved as needed to/from/between the metrology station 300 and/or the bonding station 200. Each time block may be equal. However, this is not a necessity, for example more time may be spent on pre-bond measurements (i.e. initial measurements) than post-bond measurements (i.e. subsequent measurements), meaning that T3 would be greater than T4, or vice versa.

Although Figure 4 shows multiple substrates being loaded and processed, at least one of the substrates may be passed through the apparatus 400 for bonding of further substrates. In other words, after subsequent measurement of the bonded donor and/or acceptor substrate, the apparatus 400 may configured to bond at least one further donor substrate on the bonded donor and/or acceptor substrate. For example, instead of introduction of the third acceptor substrate at T=5, instead the first bonded donor and acceptor substrate may be moved to the bonding station 200 in T=6.

A consequence of the short feedback time described in relation to Figure 4 is that control of drifts in the bonding station 200 can be controlled to a smaller time period, e.g. of the order of a few minutes/roughly equivalent to two time blocks (although for some of the parameters (e.g. pure Tx, Ty offsets) the feedback time may be closer to one time block; provided that data processing is optimized to support this). In other words, there are shorter stability duration for hardware and/or calibration. This can offer benefits in fewer/less frequent position calibrations (increasing productivity) and/or less strict requirements on hardware (potential cost savings).

In the present invention, further advantages have been realised due to the apparatus 400 being configured to carry out pre-bonding measurements and post-bonding measurements. In particular, it has been determined that these measurements can be particularly useful for measuring alignment markers pre and post bonding so as to determine overlay. Problems associated with presently known methods will be described below, followed by an embodiment for determining overlay in this way.

It is known that overlay between a donor substrate and acceptor substrate can be measured using infrared (IR) overlay tool. This tool is beneficial in that it can take measurements through a top layer of silicon, which may be of the order of 50 µm for example, but has large inaccuracy (~20nm).

Problem 1: For donor substrate to acceptor substrate (and particularly for die to wafer, D2W) bonding, application of <10nm overlay needs better metrology to probe the bonder performance. Ways to circumvent this are by sacrificing real estate (on each individual donor substrate) to enable bonded overlay measurements. It is noted that this "real estate" compromise for donor substrates (particularly for dies) may be very impactful: in some use cases the actual die sizes are as small as 1x1 mm.

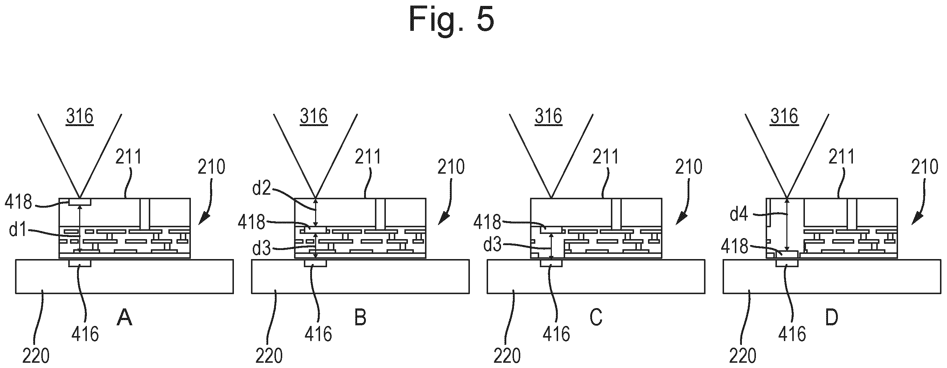

Four scenarios for such overlay measurements are depicted in Figure 5 (although there may be more).

In Figure 5A, the first mark 418 is very "visible" however the distance to the second mark 416 on the acceptor substrate (d1) is very large (>50 µm) hampering an accurate overlay measurement. Additionally, the measurement is negatively impacted by the donor substrate, e.g. due to device structures in the donor substrate between the first overlay mark 418 and the second overlay mark 416. This is deemed not feasible for measurement by an overlay sensor.

In Figure 5B, the overlay mark 418 is now buried under approximately ~ 50 µm of silicon (d2) and so near-infrared (NIR) would be used. The distance towards the second mark 416 on the acceptor wafer is not as large (d3; -microns) however, the optical path is still disturbed by the device structures in between the first overlay mark 418 and the second overlay mark 416.

Figure 5C provides a similar scenario as in Figure 5B, except that there are no device structures between the first overlay mark 418 and the second overlay mark 416. This makes overlay measurements more accurate/feasible, however, it is at the cost of "real estate" on the donor substrate.

In Figure 5D, the first (top) overlay mark 418 is right above the second mark 416, and the user is required to make a clear out in the device where there is line-of-sight from top to bottom of the donor substrate. This makes overlay measurements most ideal, but creates biggest compromise on real estate on the donor substrate and requires extra process steps.

Problem 2: For very precise bonding overlay, actuation or manipulation during the bonding might be used to reduce the impact of bonding fingerprint. The bonding fingerprint has an average and varying component, which preferably is measured soon after bonding in order to optimize/correct for next substrates/lots to be bonded. This relates to problem 1: how to obtain precise bonded overlay measurements, and also how to do this shortly after bonding to allow for a quick feedback loop.

Problem 3: Another issue with the existing donor substrate to acceptor substrate (and particularly for die to wafer, D2W) bonding, with a metrology station and bonding station 200 is severe under-utilization of the metrology station 300 (including the corresponding substrate support) and so improvements could be made to make the apparatus 400 more cost effective.

Problem 4: Another challenge is the stacking of multiple donor substrates on top of each other. In that case, the exact placement of individual donor substrates on the acceptor substrate might require even more dense alignment measurements, for example only, up to 2 markers per donor substrate.

In the present embodiment, an (indirect) but highly precise method of measuring bonded overlay in the apparatus 400 is provided as described below. The present embodiment may enable a very short feedback loop to the bonding side to improve bonding by allowing quick implementation of adjustments to the bonding settings. The present embodiment may improve (or even optimise) utilization of the metrology station 300 whilst also providing a way of measuring overlay in the apparatus 400. The present embodiment may inherently also provide a way of measuring a very dense alignment grid on the die-populated acceptor substrate (i.e. for the next round of bonding) in case of stacking multiple donor substrates (e.g. dies).

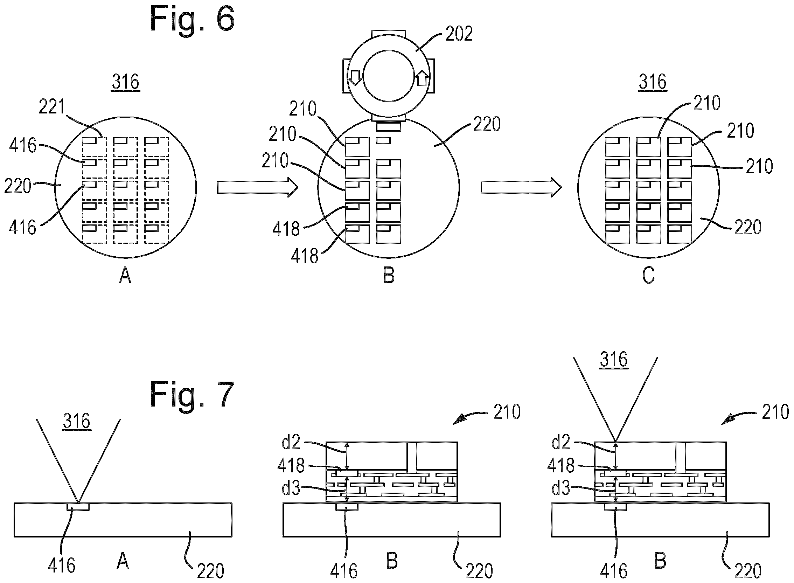

In the present embodiment, the acceptor substrate 220 comprises a donor acceptor zone 221 for each donor substrate to be received on the acceptor substrate 220, and the acceptor substrate 221 comprises at least one alignment marker 416, corresponding to each die acceptor zone 221, for example, as shown in Figures 6 and 7. The at least one alignment marker 416 may be positioned within the die acceptor zone 221 as shown in Figure 6. Alternatively, the at least one alignment 416 marker could be positioned adjacent to the die acceptor zone 221.

In the present embodiment, the apparatus 400 is configured to measure the position of the at least one alignment marker 416 prior to bonding, as shown in Figures 6A and 7A. Preferably, the apparatus 400 is configured to measure the position of all the alignment markers 416 prior to bonding. The measurements can be carried out in the metrology station 300 as described above (for example, as in T1 etc.).

When initial measurements have been carried out on the acceptor substrate 220, e.g. the first acceptor substrate 220-1, the acceptor substrate is moved to the bonding station 200 (as indicated by the arrow between figures 6A and 6B, and between figures 7A and 7B). The apparatus 400 is configured to bond each of the donor substrates 210 to the acceptor substrate 220, for example, as shown in Figures 6b and 7B. In the present embodiment, each of the donor substrates 210 which are to be bonded to the acceptor substrate 220 comprises at least one alignment marker 418. The alignment marker 418 on the donor substrate 210 may be positioned near or at the surface of the donor substrate, i.e. the back surface 211, as shown in Figure 5A. This may be beneficial in that a measurement can be made when the donor substrate 210 is bonded without having to look through any silicon of the donor substrate 210. At least one of the donor substrates 210 may comprise more than one alignment marker (not shown). The apparatus 400 is configured to move the bonded donor substrates and acceptor substrate back to the metrology station 300 (as indicated by the arrow between figures 6B and 6C, and between figures 7B and 7C). It is noted that the acceptor substrate 220 is held by the same substrate support during initial measuring, bonding and subsequent measuring (i.e. throughout Figures 6A-C and 7A-C). Thus, the initial measurements of the alignment markers on the acceptor substrate are still applicable. Although there is an assumption that the acceptor substrate will not be deformed during bonding.

In the present embodiment, the apparatus 400 is configured to measure the position of the at least one die alignment marker 418 on the bonded die and acceptor substrate. Specifically, in the present embodiment, the apparatus 400 is configured to measure the position of the alignment marker 418 on each bonded substrate which has been bonded acceptor substrate. This is shown in Figures 6C and 7C.

In the present embodiment, the apparatus 400 is configured to determine overlay from the measurement of the alignment markers. The overlay can be determined by comparing the measurements of the alignment marker for a donor substrate when bonded on the acceptor substrate with the initial measurement of the corresponding alignment marker on the acceptor substrate.

A major advantage of this "indirect overlay" measurement is that it does not need two markers to be right on top of each other (e.g. as in Figure 5D). In the present embodiment, there does not need to be measurement from the first to second alignment marker, i.e. of both alignment markers together or of the lower alignment marker through the donor substrate. Thus, it does not matter if there are device features in between the alignment markers as in Figures 5A and 5B, and so the claim on real estate can be smaller.

The overlay determined in the present invention can be used to (feed forward) improve the bonding accuracy in following bonding steps. The advantage of the present embodiment is that the feedback loop will be very short (potentially per substrate, or more likely every other substrate), enabling very strict process control. This is particularly important for die to substrate bonding because yield sensitivity may be extremely high as this process is at the very end of the line, i.e. nearly finished devices.

The present embodiment is advantageous in that the overlay can be determined without the need for an external overlay measurement tool (outside of the apparatus 400) which could increase cost and provide slower feedback. Furthermore, the accuracy of the overlay determined indirectly from the alignment markers might be the same as, or even better than using some known external overlay measurement tools.

There may also be advantages for using the present embodiment when multiple donor substrates are stacked on an acceptor substrate. The overlay measurements after bonding may be reused for further rounds of bonding on the (already bonded) substrate. That implies that when the substrate is loaded for the second round of bonding, it is not necessary to re-measure all bonded donor substrates again, but for example, a coarse grid of 100 markers may be sufficient. This would allow for plenty of measurement time after that second bonding step to measure the overlay of the second bonded donor substrate (i.e. the second stacked donor substrate bonded to the first bonded donor substrate bonded to the acceptor substrate).

In the above embodiments, the processes shown include carrying out measurements on acceptor substrates (which may or may not already have a donor substrate affixed) before a specific bonding process, carrying out the bonding process, and then carrying out further measurements on the bonded donor substrate and/or acceptor substrate after the bonding process. As previously noted, the donor substrates may be provided on a carrier substrate 209. The carrier substrate may be used to provide the donor substrates in the bonding station 200, for example as shown in Figure 2. The apparatus 400 may be configured to measure at least one characteristic of at least one donor substrate and/or a carrier substrate in the metrology station 300, whilst simultaneously bonding at least one donor substrate to an acceptor substrate in the bonding station 200.

In other words, the apparatus 400 can be used to measure deformations of donor substrates by measuring the donor substrates and/or the carrier substrate on which the donor substrates are temporarily transported prior to bonding.

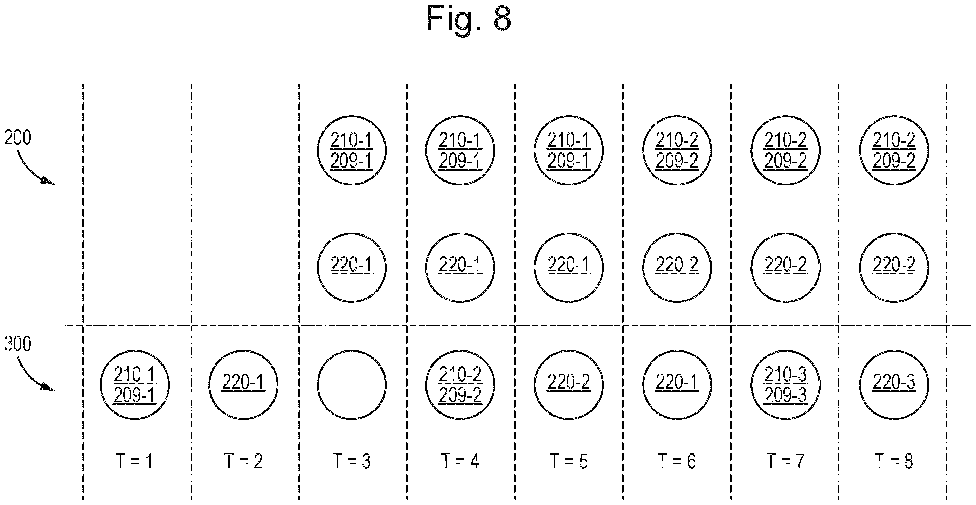

The apparatus 400 may carry out initial measurements of the donor substrates and/or the carrier substrates before or after initial measurement of an acceptor substrate. For example, in any of the timeblocks shown in Figure 4, the metrology station 300 may be configured to carry out initial measurements on the donor substrates and/or the carrier substrate. This may amount to effectively splitting timeblock T=1, T=3, etc so that both the acceptor substrate and the donor substrates and/or carrier substrates can be measured prior to bonding. This is shown in Figure 8, wherein a first set of at least one donor substrate 210-1 and/or the carrier substrate 209-1 is initially measured in T=1, a corresponding acceptor substrate is initially measured in T=2, and the first set of at least one donor substrate 210-1 and the first acceptor substrate 220-1 are bonded in T=3, 4, 5. During bonding, (i.e. at T=4), a second set of at least one donor substrate 210-2 and/or a second carrier substrate 209-2 is initially measured. During bonding, (i.e. at T=5), a second acceptor substrate is initially measured. It is noted that the measurements taking place at T=4 and T=5 may be swapped. The second set of at least one donor substrate 210-2 and the second acceptor substrate 220-2 are bonded in T=6, 7, 8. During bonding, (i.e. at T=6), the bonded first set of at least one donor substrate 210-1 and first acceptor substrate 220-1 can be subsequently measured. Additionally, a third set of at least one donor substrate 210-3 and/or a third carrier substrate 209-3 is initially measured in T=7, a third acceptor substrate 220-3 is initially measured in T=8. It is noted that the measurements taking place at T=6, 7 and 8 may be swapped. However, there is a benefit to measuring the bonded substrate before other measurements so that the data from the measurements of the bonded substrate can be taken into account as soon as possible in any further or other ongoing processes.

The apparatus 400 may comprise an additional handling system to move the carrier substrate holding donor substrates under the measurement station (or move the measurement station to a good position to measure the donor substrates on the carrier substrate). This could be implemented with 2 or 3 entrances to the metrology station 300. In this case, each of the donor substrate(s) (prior to bonding), carrier substrate (prior to bonding), and acceptor substrate (prior to bonding) can be measured in the metrology station 300, as well as the (post-)bonded substrate, which comprises the donor substrate(s) and the acceptor substrate which have been bonded together.

In the present embodiment, the apparatus 400 is configured to measure initially at least one characteristic of at least one further die and/or a further carrier substrate. In other words, the apparatus 400 can be used to carry out ongoing measurements of further sets of at least one donor substrate provided on a further carrier substrate.

The sampling scheme of any of the above embodiments may be optimized to measure both sides or one side: die deformation and global wafer deformation at the same position. In further detail, the donor substrate (to be bonded, or after bonding) can be deformed, and the acceptor waver (before bonding, but certainly after bonding) can be deformed. The sampling scheme can be selected (i.e. with respect to which marks are measured) so as to obtain sufficient information to determine one or both types of deformation.

In any of the above embodiments, the measurements obtained relating to the bonded substrates (i.e. at least one donor substrate and at least one acceptor substrate) can be used for determining/calculation errors and/or corrections including corrections of translation offset, magnification, rotation, etc.. Such data, comprising the measurements (and/or corresponding errors and/or corrections) may be used in any appropriate way. For example, the data could be provided back to the bonding station 200 so that adjustments can be made. For example, from the measurement of the bonded donor and/or acceptor substrate may be used to adjust at least one setting in the bonding station 200, such as a position of the stage 202.

Additionally or alternatively, apparatus 400 may be configured to determine, based on data obtained in the initial and/or subsequent measurements, whether quality thresholds for the measured substrate have been met. For example, quality thresholds may be set (e.g. based on user input) relating to various parameters/measurements. The measurements taken (initially and/or subsequently) may be compared (directly e.g. based on measured values, or indirectly e.g. based on determinations/calculations using the measured values) with at least one threshold to determine whether the threshold is met (i.e. whether the measured substrate has certain criteria). The apparatus 400 may be configured to inform the user if a threshold is not met, for example, via a display on the apparatus, preferably with details of the measurement and/or threshold not met.

Additionally or alternatively, the data can be provided data obtained in the initial and/or subsequent measurement may be used in a control loop comprising at least one apparatus which processes and/or forms the donor substrate, carrier substrate and/or acceptor substrate. In other words, data from the measurements (initial and/or subsequent) may be used as feedback for external systems and/or apparatus which have been used to process or otherwise form the substrates used in the bonding process, e.g. any of the donor substrate, carrier substrate and/or acceptor substrate. For example, the initial and/or subsequent measuring may comprise obtaining metrology data comprising values of one or more performance parameters associated with the donor substrate and/or the acceptor substrate, modeling the metrology data to a representation compliant with a control interface of an apparatus used in processing of at least one of the donor and/or acceptor substrate, and configuring the apparatus by providing the modeled metrology data to the control interface of the apparatus. Thus, data from the measurements (initial and/or subsequent) can be modelled so as to be provided in a form which is compatible with a control interface of an apparatus used for processing of the substrates (e.g. at a stage other than in the metrology and/or bonding stations) and the data can be used for adjusting the apparatus. Thus, the measurements obtained in any of the embodiments or variations disclosed herein may be used for enabling control loops, e.g. by creating input for control loops towards the lithography scanners. In other words, the method (and/or apparatus described above) may be part of a holistic lithography method or apparatus/system.

In line with the above, in an embodiment, a method is provided of configuring an apparatus used in processing semiconductor substrates. The method comprising: obtaining metrology data comprising values of one or more performance parameters associated with a substrate after or before being subject to a process of bonding the substrate to a further substrate; modeling the metrology data to a representation compliant with a control interface of the apparatus; and configuring the apparatus by providing the modeled metrology data to the control interface of the apparatus. The method may comprise bonding the substrate and the further substrate (for example as described in any of the above embodiments or variations). The method may comprise using the data in a control loop comprising at least one apparatus which processes and/or forms the substrate and/or further substrate.

Although it is described above that the sensor in the metrology station 300 is an alignment sensor 316, the metrology station 300 may comprise any appropriate sensor. The metrology station 300 may additionally or alternatively include an overlay sensor. Use of an overlay sensor allows for direct overlay measurements to be done in any "spare" time available at the measurement side (before or after bonding). The sensor may be a combined alignment and overlay sensor, i.e. may have combined alignment and overlay measurement capabilities. Such a combined sensor has been demonstrated where separate alignment images and overlay images are created (e.g. on the camera) and acquired
separately. The benefit of this combined sensor is that it can be built into a volume equal or similar to that of the some known alignment sensors, thus allowing an upgrade to these capabilities without requiring additional space or redetermining layout of the metrology station 300. For example, the metrology sensor may comprise a sensor as disclosed in WO 2020057900 A1, which is hereby incorporated by reference in its entirety, in particular, for example, figure 9 and the corresponding description of the measurement of the target of figure 9. Optionally, the metrology station 300 may comprise a level sensor configured to detect height data of at least one of the substrates.

In the embodiments described herein, various operations are described as being carried out simultaneously. It will be understood that this means that the operations as a whole are to be carried out at generally the same time, e.g. ongoing initial measurements may be carried out throughout the bonding of dies, and/or ongoing bonding of dies may be carried out at the same time as steps are taken to implement subsequent measurements. Thus, the steps of different procedures can be carried out at the same time, and it is not required that specific steps within each of these procedures are carried out at the exact second, millisecond or nanosecond etc that a step in another procedure is being carried out. It will be understood that different procedures carried out simultaneously are carried out on different substrates, and so each substrate may be at a different stage in the overall process.

The apparatus 400 described above can be used for carrying out a method of measuring at least one characteristic of a bonded donor and/or acceptor substrate in an apparatus 400 for bonding at least one donor substrate to an acceptor substrate. The method of the present invention may include some of, or all of, the steps described above.

In one embodiment, a method of measuring at least one characteristic of a bonded donor and/or acceptor substrate in an apparatus 400 for bonding at least one donor substrate to an acceptor substrate is provided. The method comprising: in a metrology station 300 of the apparatus 400, measuring initially at least one characteristic of at least one donor substrate, a carrier substrate configured to support the at least one donor substrate prior to bonding and/or an acceptor substrate; in a bonding station 200 of the apparatus 400, bonding at least one donor substrate to the acceptor substrate; and in the metrology station 300 of the apparatus 400, measuring subsequently at least one characteristic of the bonded donor and/or acceptor substrate. The method may comprise moving the donor substrate and/or the acceptor substrate from the metrology station 300 to the bonding station 200. The method may comprise moving the bonded donor and acceptor substrate from the bonding station 200 to the metrology station 300. After subsequent measurement of the bonded donor and/or acceptor substrate, the method may further comprise bonding at least one further donor substrate on the bonded donor and/or acceptor substrate (i.e. additional substrates may be stacked onto an already bonded donor substrate and/or already bonded acceptor substrate). Additionally or alternatively, the method may further comprising measuring initially at least one characteristic of at least one further donor substrate and/or a further carrier substrate and/or a further acceptor substrate.

As described above, various stages of the method can be carried out simultaneously. For example, initial measuring and the bonding may be carried out simultaneously, and/or subsequent measuring and the bonding are carried out simultaneously. In further detail, the method may comprise moving a first acceptor substrate from the metrology station 300 to the bonding station 200, receiving a second acceptor substrate in the metrology station 300, and measuring at least one characteristic of the second acceptor substrate whilst simultaneously bonding at least one donor substrate to the first acceptor substrate. The method may further comprise moving the at least one bonded donor and first acceptor substrate from the bonding station 200 to the metrology station 300 and moving the second acceptor substrate from the metrology station 300 to the bonding station 200. The method may further comprise measuring at least one characteristic of the at least one bonded donor and first acceptor substrate whilst simultaneously bonding at least one donor substrate to the second acceptor substrate, receiving a third acceptor substrate in the metrology station 300, and measuring at least one characteristic of the third acceptor substrate whilst simultaneously bonding at least one donor substrate to the second acceptor substrate.

As described above, the metrology station 300 may comprise an alignment sensor 316 and/or an overlay sensor, although any appropriate sensor may be used. Thus, the method may comprise making alignment measurements, and/or overlay measurements and/or level/height measurements etc.

In an embodiment, the acceptor substrate comprises a donor acceptor zone for each donor substrate to be received on the acceptor substrate, and the acceptor substrate comprises at least one alignment marker corresponding to each donor acceptor zone. The at least one alignment marker may be positioned within the donor acceptor zone, or the at least one alignment marker may be positioned adjacent to the donor acceptor zone. In this embodiment, the initial measuring comprises measuring the position of the at least one alignment marker prior to bonding. Each donor substrate may comprise at least one donor alignment marker. The subsequent measuring may comprise measuring the position of the at least one donor substrate alignment marker on the bonded donor and substrate. When the position of the at least one alignment marker is measured prior to bonding and the position of the at least one donor substrate alignment marker is measured on the bonded donor and substrate, the method may comprise determining overlay from the measurement of the alignment markers.

In an embodiment, the initial measuring comprises measuring at least one characteristic of at least one donor substrate and/or a carrier substrate in the metrology station 300, whilst simultaneously bonding at least one donor substrate to the acceptor substrate in the bonding station 200.

As described above, the measurements made prior or post bonding can be used in a number of ways. For example, the method may comprise using feedback from the measurement of the bonded donor and/or acceptor substrate to adjust at least one setting in the bonding station 200. Additionally or alternatively, the method may use data obtained in the initial and/or subsequent measurement in a control loop comprising at least one apparatus which processes and/or forms the donor substrate, carrier substrate and/or acceptor substrate. Additionally or alternatively, the initial and/or subsequent measuring may comprise obtaining metrology data comprising values of one or more performance parameters associated with the donor substrate and/or the acceptor substrate, modeling the metrology data to a representation compliant with a control interface of an apparatus is used in processing of at least one of the donor and/or acceptor substrate, and configuring the apparatus by providing the modeled metrology data to the control interface of the apparatus. Additionally or alternatively, the method may comprise determining, based on data obtained in the initial and/or subsequent measurements, whether quality thresholds for the measured substrate have been met.

In an embodiment, a method is provided of configuring an apparatus used in processing semiconductor substrates. The method comprising: obtaining metrology data comprising values of one or more performance parameters associated with a substrate after or before being subject to a process of bonding the substrate to a further substrate; modeling the metrology data to a representation compliant with a control interface of the apparatus; and configuring the apparatus by providing the modeled metrology data to the control interface of the apparatus. The method may comprise bonding the substrate and the further substrate (for example as described in any of the above embodiments or variations). The method may comprise using the data in a control loop comprising at least one apparatus which processes and/or forms the substrate and/or further substrate.

The apparatus as described in any of the above embodiments or variations may be configured to carry out any of the methods disclosed herein.

Although the above embodiments are described in combination with the bonding tool shown in figure 2, it will be understood that the bonding station 200 may comprise any appropriate bonding tool or mechanism for bonding at least one die to a substrate. Bonding tools other than those described could be used in combination with any of the above embodiments. The bonding station 200 may comprise multiple bonding tools, e.g. multiple stages 202.

The methods of the present invention may be performed by computer systems comprising one or more computers. A computer used to implement the invention may comprise one or more processors, including general purpose CPUs, graphical processing units (GPUs), tensor processing units (TPU) or other specialised processors. A computer used to implement the invention may be physical or virtual. A computer used to implement the invention may be a server, a client or a workstation. Multiple computers used to implement the invention may be distributed and interconnected via a network such as a local area network (LAN) or wide area network (WAN). Individual steps of the method may be carried out by a computer system but not necessarily the same computer system. Results of a method of the invention may be displayed to a user or stored in any suitable storage medium. The present invention may be embodied in a non-transitory computer-readable storage medium that stores instructions to carry out a method of the invention. Any suitable programming language may be used to implement the invention. The present invention may be embodied in a computer system comprising one or more processors and memory or storage storing instructions to carry out a method of the invention.

Further embodiments are disclosed in the subsequent numbered list:
1. An apparatus for bonding at least one die to a substrate, the apparatus comprising:
   a metrology station within the apparatus, the metrology station comprising at least one sensor, and
   a bonding station within the apparatus, the bonding station being configured to bond at least one donor substrate to an acceptor substrate,
   wherein the apparatus is configured to measure initially, using the sensor in the metrology station, at least one characteristic of the at least one donor substrate, a carrier substrate configured to support the at least one donor substrate prior to bonding and/or the acceptor substrate, to bond the at least one donor substrate to the acceptor substrate in the bonding station, and to measure subsequently at least one characteristic of the bonded donor and/or acceptor substrate in the metrology station.
2. The apparatus of clause 1, wherein the apparatus is configured to move the donor substrate and/or the acceptor substrate from the metrology station to the bonding station.
3. The apparatus of either of clauses 1 or 2, wherein the apparatus is configured to move the bonded donor and acceptor substrate from the bonding station to the metrology station.
4. The apparatus of any one of clauses 1 to 3, wherein, after subsequent measurement of the bonded donor and/or acceptor substrate, the apparatus is configured to bond at least one further donor substrate on the bonded donor and/or acceptor substrate.
5. The apparatus of any one of the preceding clauses, wherein the apparatus is configured to measure initially at least one characteristic of at least one further donor substrate and/or a further carrier substrate and/or a further acceptor substrate.
6. The apparatus of any one of the preceding clauses, wherein the apparatus is configured to carry out simultaneously the initial measuring and the bonding.
7. The apparatus of any one of the preceding clauses, wherein the apparatus is configured to carry out simultaneously the bonding and the subsequent measuring.
8. The apparatus of any one of the preceding clauses, wherein the apparatus is configured to move a first acceptor substrate from the metrology station to the bonding station, to receive a second acceptor substrate in the metrology station, and to measure at least one characteristic of the second acceptor substrate whilst simultaneously bonding at least one donor substrate to the first acceptor substrate.
9. The apparatus of clause 8, wherein the apparatus is configured to move the at least one bonded donor and first acceptor substrate from the bonding station to the metrology station and to move the second acceptor substrate from the metrology station to the bonding station.
10. The apparatus of clause 9, wherein the apparatus is configured to measure at least one characteristic of the at least one bonded donor and first acceptor substrate whilst simultaneously bonding at least one donor substrate to the second acceptor substrate, to receive a third acceptor substrate in the metrology station, and to measure at least one characteristic of the third acceptor substrate whilst simultaneously bonding at least one donor substrate to the second acceptor substrate.
11. The apparatus of any one of the preceding clauses, further comprising using feedback from the measurement of the bonded donor and/or acceptor substrate to adjust at least one setting in the bonding station.
12. The apparatus of any one of the preceding clauses, wherein the metrology station comprises an alignment sensor and/or an overlay sensor
13. The apparatus of any one of the preceding clauses, wherein the acceptor substrate comprises a donor acceptor zone for each donor substrate to be received on the acceptor substrate, and the acceptor substrate comprises at least one alignment marker corresponding to each donor acceptor zone.
14. The apparatus of clause 13, wherein the at least one alignment marker is positioned within the donor acceptor zone.
15. The apparatus of clause 13, wherein the at least one alignment marker is positioned adjacent to the donor acceptor zone.
16. The apparatus of any one of clauses 13 to 15, wherein the apparatus is configured to measure the position of the at least one alignment marker prior to bonding.
17. The apparatus of any one of clauses 13 to 16, wherein each donor substrate comprises at least one alignment marker.
18. The apparatus of clause 17, wherein the apparatus is configured to measure the position of the at least one donor alignment marker on the bonded donor and acceptor substrate.
19. The apparatus of clause 16, wherein each donor substrate comprises at least one alignment marker and the apparatus is configured to measure the position of the at least one donor alignment marker on the bonded donor and acceptor substrate, and wherein the tool is configured to determine overlay from the measurement of the alignment markers.
20. The apparatus of any one of the preceding clauses, wherein the apparatus is configured to measure at least one characteristic of at least one donor substrate and/or a carrier substrate in the metrology station, whilst simultaneously bonding at least one donor substrate to the acceptor substrate in the bonding station.
21. The apparatus of any one of the preceding clauses, wherein the apparatus comprises a first substrate support structure and a second substrate support structure, wherein each substrate support structure is configured to move between at least the metrology station and the bonding station.
22. A method of measuring at least one characteristic of a bonded donor and/or acceptor substrate in an apparatus for bonding at least one donor substrate to an acceptor substrate, the method comprising:
   in a metrology station of the apparatus, measuring initially at least one characteristic of at least one donor substrate, a carrier substrate configured to support the at least one donor substrate prior to bonding and/or an acceptor substrate;
   in a bonding station of the apparatus, bonding at least one donor substrate to the acceptor substrate; and
   in the metrology station of the apparatus, measuring subsequently at least one characteristic of the bonded donor and/or acceptor substrate.
23. The method of clause 22, further comprising moving the donor substrate and/or the acceptor substrate from the metrology station to the bonding station.
24. The method of either of clauses 22 or 23, further comprising moving the bonded donor and acceptor substrate from the bonding station to the metrology station.
25. The method of any one of clauses 22 to 24, wherein, after subsequent measurement of the bonded donor and/or acceptor substrate, further comprising bonding at least one further donor substrate on the bonded donor and/or acceptor substrate.
26. The method of any one of clauses 22 to 25, further comprising measuring initially at least one characteristic of at least one further donor substrate and/or a further carrier substrate and/or a further acceptor substrate.
27. The method of any one of clauses 22 to 26, wherein initial measuring and the bonding are carried out simultaneously.
28. The method of any one of clauses 22 to 27, wherein the subsequent measuring and the bonding are carried out simultaneously.
29. The method of any one of clauses 22 to 28, further comprising moving a first acceptor substrate from the metrology station to the bonding station, receiving a second acceptor substrate in the metrology station, and measuring at least one characteristic of the second acceptor substrate whilst simultaneously bonding at least one donor substrate to the first acceptor substrate.
30. The method of clause 29, further comprising moving the at least one bonded donor and first acceptor substrate from the bonding station to the metrology station and moving the second acceptor substrate from the metrology station to the bonding station.
31. The method of clause 30, further comprising measuring at least one characteristic of the at least one bonded donor and first acceptor substrate whilst simultaneously bonding at least one donor substrate to the second acceptor substrate, receiving a third acceptor substrate in the metrology station, and measuring at least one characteristic of the third acceptor substrate whilst simultaneously bonding at least one donor substrate to the second acceptor substrate.
32. The method of any one of clauses 22 to 31, further comprising using feedback from the measurement of the bonded donor and/or acceptor substrate to adjust at least one setting in the bonding station.
33. The method of any one of clauses 22 to 32, wherein the metrology station comprises an alignment sensor and/or an overlay sensor
34. The method of any one of clauses 22 to 33, wherein the acceptor substrate comprises a donor acceptor zone for each donor substrate to be received on the acceptor substrate, and the acceptor substrate comprises at least one alignment marker corresponding to each donor acceptor zone.
35. The method of clause 34, wherein the at least one alignment marker is positioned within the donor acceptor zone.
36. The method of clause 34, wherein the at least one alignment marker is positioned adjacent to the donor acceptor zone.
37. The method of any one of clauses 34 to 36, wherein initial measuring comprises measuring the position of the at least one alignment marker prior to bonding.
38. The method of any one of clauses 34 to 37, wherein each donor substrate comprises at least one donor alignment marker.
39. The method of clause 38, wherein the subsequent measuring comprises measuring the position of the at least one donor substrate alignment marker on the bonded donor and substrate.
40. The method of clause 37, wherein each donor substrate comprises at least one alignment marker and the subsequent measuring comprises measuring the position of the at least one donor substrate alignment marker on the bonded donor and substrate, and further comprising determining overlay from the measurement of the alignment markers.
41. The method of any one of clause 22 to 40, wherein the initial measuring comprises measuring at least one characteristic of at least one donor substrate and/or a carrier substrate in the metrology station, whilst simultaneously bonding at least one donor substrate to the acceptor substrate in the bonding station.
42. The method of any one of clauses 22 to 41, further comprising using data obtained in the initial and/or subsequent measurement in a control loop comprising at least one apparatus which processes and/or forms the donor substrate, carrier substrate and/or acceptor substrate.
43. The method of any one of clauses 22 to 42, wherein the initial and/or subsequent measuring comprises obtaining metrology data comprising values of one or more performance parameters associated with the donor substrate and/or the acceptor substrate, modeling the metrology data to a representation compliant with a control interface of an apparatus is used in processing of at least one of the donor and/or acceptor substrate, and configuring the apparatus by providing the modeled metrology data to the control interface of the apparatus.
44. The method of any one of clauses 22 to 43, further determining, based on data obtained in the initial and/or subsequent measurements, whether quality thresholds for the measured substrate have been met.
45. A method of configuring an apparatus used in processing semiconductor substrates, the method comprising:
   obtaining metrology data comprising values of one or more performance parameters associated with a substrate after or before being subject to a process of bonding the substrate to a further substrate using the apparatus of any one of clauses 1 to 21;
   modeling the metrology data to a representation compliant with a control interface of the apparatus; and
   configuring the apparatus by providing the modeled metrology data to the control interface of the apparatus.
46. The method of either of clause 44, further comprising bonding the substrate and the further substrate.
47. The method of either of clauses 45 or 46, further comprising using the data in a control loop comprising at least one apparatus which processes and/or forms the substrate and/or further substrate.
48. The apparatus of any one of clauses 1 to 21 being configured to carry out the method of any one of clauses 22 to 47.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

While the present invention has been described in connection with various embodiments, other embodiments of the invention will be apparent to those skilled in the art from consideration of the specification and practice of the invention disclosed herein. In addition, the combination and subcombinations of disclosed elements may comprise separate embodiments. For example, one or more of the operations described above may be included in separate embodiments, or they may be included together in the same embodiment. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. An apparatus for bonding at least one die to a substrate, the apparatus comprising:
a metrology station within the apparatus, the metrology station comprising at least one sensor, and
a bonding station within the apparatus, the bonding station being configured to bond at least one donor substrate to an acceptor substrate,
wherein the apparatus is configured to measure initially, using the sensor in the metrology station, at least one characteristic of the at least one donor substrate, a carrier substrate configured to support the at least one donor substrate prior to bonding and/or the acceptor substrate, to bond the at least one donor substrate to the acceptor substrate in the bonding station, and to measure subsequently at least one characteristic of the bonded donor and/or acceptor substrate in the metrology station.

2. The apparatus of claim 1, wherein the apparatus is configured to move the donor substrate and/or the acceptor substrate from the metrology station to the bonding station.

3. The apparatus of either of claims 1 or 2, wherein the apparatus is configured to move the bonded donor and acceptor substrate from the bonding station to the metrology station.

4. The apparatus of any one of claims 1 to 3, wherein, after subsequent measurement of the bonded donor and/or acceptor substrate, the apparatus is configured to bond at least one further donor substrate on the bonded donor and/or acceptor substrate.

5. The apparatus of any one of the preceding claims, wherein the apparatus is configured to measure initially at least one characteristic of at least one further donor substrate and/or a further carrier substrate and/or a further acceptor substrate.

6. The apparatus of any one of the preceding claims, wherein the apparatus is configured to carry out simultaneously the initial measuring and the bonding.

7. The apparatus of any one of the preceding claims, wherein the apparatus is configured to carry out simultaneously the bonding and the subsequent measuring.

8. The apparatus of any one of the preceding claims, wherein the apparatus is configured to move a first acceptor substrate from the metrology station to the bonding station, to receive a second acceptor substrate in the metrology station, and to measure at least one characteristic of the second acceptor substrate whilst simultaneously bonding at least one donor substrate to the first acceptor substrate.

9. The apparatus of claim 8, wherein the apparatus is configured to move the at least one bonded donor and first acceptor substrate from the bonding station to the metrology station and to move the second acceptor substrate from the metrology station to the bonding station, and, optionally, wherein the apparatus is configured to measure at least one characteristic of the at least one bonded donor and first acceptor substrate whilst simultaneously bonding at least one donor substrate to the second acceptor substrate, to receive a third acceptor substrate in the metrology station, and to measure at least one characteristic of the third acceptor substrate whilst simultaneously bonding at least one donor substrate to the second acceptor substrate.

10. The apparatus of any one of the preceding claims, further comprising using feedback from the measurement of the bonded donor and/or acceptor substrate to adjust at least one setting in the bonding station.

11. The apparatus of any one of the preceding claims, wherein the acceptor substrate comprises a donor acceptor zone for each donor substrate to be received on the acceptor substrate, and the acceptor substrate comprises at least one alignment marker corresponding to each donor acceptor zone.

12. The apparatus of any one of the preceding claims, wherein the apparatus is configured to measure at least one characteristic of at least one donor substrate and/or a carrier substrate in the metrology station, whilst simultaneously bonding at least one donor substrate to the acceptor substrate in the bonding station.

13. The apparatus of any one of the preceding claims, wherein the apparatus comprises a first substrate support structure and a second substrate support structure, wherein each substrate support structure is configured to move between at least the metrology station and the bonding station.

14. A method of measuring at least one characteristic of a bonded donor and/or acceptor substrate in an apparatus for bonding at least one donor substrate to an acceptor substrate, the method comprising:
in a metrology station of the apparatus, measuring initially at least one characteristic of at least one donor substrate, a carrier substrate configured to support the at least one donor substrate prior to bonding and/or an acceptor substrate;
in a bonding station of the apparatus, bonding at least one donor substrate to the acceptor substrate; and
in the metrology station of the apparatus, measuring subsequently at least one characteristic of the bonded donor and/or acceptor substrate.

15. A method of configuring an apparatus used in processing semiconductor substrates, the method comprising:
obtaining metrology data comprising values of one or more performance parameters associated with a substrate after or before being subject to a process of bonding the substrate to a further substrate using the apparatus of any one of claims 1 to 13;
modeling the metrology data to a representation compliant with a control interface of the apparatus; and
configuring the apparatus by providing the modeled metrology data to the control interface of the apparatus.
